# EUROPÄISCHE PATENTSCHRIFT

(11) **EP 0 953 877 B1**
(45) Veröffentlichungstag und Bekanntmachung des Hinweises auf die Patenterteilung: **10.12.2003**
(21) Anmeldenummer: 99108181.1
(22) Anmeldetag: 26.04.1999
(51) Int. Cl.: G03F 7/12, G03F 7/24

(54) **Verfahren zur Herstellung von Siebdruckformen sowie eine Belichtungsvorrichtung hierfür**
Method for producing screen-printing forms and light exposure apparatus therefor
Procédé pour la production de pochoirs sérigraphiques et dispositif d'exposition associé

(30) Priorität: 29.04.1998 DE 19819064
(43) Veröffentlichungstag der Anmeldung: 03.11.1999
(73) Patentinhaber: CST GmbH, 47809 Krefeld (DE)
(72) Erfinder: Klenk, Dieter Dipl.-Psych., 82110 Germering (DE); Kallweit, Harry Dr., 74918 Angelbachtal (DE); Spies, Gerhard, 69234 Dielheim (DE); Kesper, Peter, 47800 Krefeld (DE)
(74) Vertreter: COHAUSZ & FLORACK

(56) Entgegenhaltungen:
- EP-A- 0 528 285
- EP-A- 0 658 812
- EP-A- 0 785 474
- DE-A- 19 545 821

## Beschreibung

Die Erfindung betrifft ein Verfahren und eine Vorrichtung zur Herstellung von Siebdruckformen durch selektive Belichtung von deren lichtempfindlicher Beschichtung, bei dem ein Belichtungssystem mit einer einen Lichtstrahl erzeugenden Lichtquelle mittels einer digitale Signale liefernden Signalquelle derart gesteuert wird, daß die gewünschten Stellen der Beschichtung belichtet werden. Sie betrifft desweiteren eine Belichtungsvorrichtung der Durchführung dieses Verfahrens mit einer Halterung für die Siebdruckform, einem Belichtungssytem, das eine einen Lichtstrahl erzeugende Lichtquelle und einen Lichtausgang aufweist, und mit einer digitale Signale liefernden Signalquelle, welche mit dem Belichtungssystem in der Weise in Verbindung steht, daß entsprechend den Signalen die gewünschten Stellen des Schablonenmaterials belichtbar sind.

Für den Sieb- und Filmdruck werden verschiedene Siebdruckformen verwendet. Für den Flachsiebdruck sind dies ebene Siebdruckformen, die einen Schablonenträger aus einem feinen Kunststoff- oder Metallgewebe mit definierter Maschengröße aufweisen, welche auf einen rechteckigen Siebdruckrahmen aufgespannt ist. Für den Rotationssiebdruck kommt eine zylindrische Druckform zur Anwendung, bei der sich der Schablonenträger als zylindrischer Mantel zwischen zwei Endringen erstreckt.

Um ein bestimmtes Druckbild zu erhalten, werden Teile des Schablonenträgers mittels eines Schablonenmaterials undurchlässig gemacht. Die undurchlässigen Bereiche bilden dann die Siebdruckschablone. Für die Herstellung der Siebdruckschablone wird auf dem Schablonenträger zunächst ganzflächig lichtempfindliches Schablonenmaterial in flüssiger Form aufgetragen, beispielsweise durch Rakeln, Spritzen, Tauchen, Streichen etc. Dabei sind zwei Arten von Schablonenmaterial bekannt.

Bei dem einen Schablonenmaterial werden die Stellen, die belichtet werden, photochemisch gehärtet (Negativ-Resist). In den anderen Bereichen bleibt das Schablonenmaterial wasserlöslich. In einem nachfolgenden Entwicklungsprozeß wird der Schablonenträger an den unbelichteten Bereichen freigelegt, d.h. das Schablonenmaterial herausgewaschen, während die belichteten Bereiche an dem Schablonenträger fixiert werden. Gegebenenfalls kann sich noch eine Härtung anschließen. Das andere Schablonenmaterial (Positiv-Resist) ist so ausgebildet, daß die belichteten Bereiche mit bestimmten Substanzen ausgewaschen werden können, während die unbelichteten Teile wasserund alkalifest sind.

Die Belichtung erfolgt gewöhnlich mit Hilfe einer als Diapositiv ausgebildeten Kopiervorlage. Hierzu wird eine geeignete Lichtquelle vorzugsweise mit hohen UV- und blau-aktinischen Lichtanteilen verwendet, beispielsweise Metall-Halogenidlampen, Quecksilberdampflampen, aber auch aktinische Leuchtstoffröhren.

In neuerer Zeit wird versucht, die Vorlage zu digitalisieren und die digitalisierten Signale zur Steuerung eines Lasers zu verwenden. Über die Signale wird der Laser gezielt ein- und ausgeschaltet. Durch fortschreitende Bewegung wird die lichtempfindliche Beschichtung selektiv belichtet. Die Anzahl der verwendeten Laserstrahlen ist auf den verwendeten Split begrenzt und kann ein bis mehrere Hundert Strahlen pro Laserkopf betragen. Allerdings ist damit auch die Wellenlänge des eingesetzten Lichtes (z.B. 488 nm oder 351 nm) festgelegt. Es kann somit nur ein Beschichtungsmaterial verwendet werden, das in dem jeweiligen Bereich lichtempfindlich ist.

Die Druckschrift EP-A-0 785 474 offenbart ein Verfahren zur Herstellung von Flexodruckschablonen wobei ein Steuerrechner ein Belichtungssystem mit einem Laser und einem Umlenkspiegel mustergemäß vor der Druckform entlang verschiebt und das Laser ein - und ausschaltet.

Abgesehen davon, daß in beiden Fällen nur spezielles Beschichtungsmaterial angewendet werden kann, ist der apparative Aufwand sehr hoch.

Der Erfindung liegt somit die Aufgabe zugrunde, ein Verfahren zur Herstellung von Siebdruckformen bereitzustellen, das trotz Verwendung digitaler Signale mit relativem geringem apparativen Aufwand auskommt und zudem für die handelsüblichen Schablonenmaterialien geeignet ist. Eine weitere Aufgabe besteht darin, eine Belichtungsvorrichtung so zu konzipieren, daß digitalisierte Signale bei niedrigem apparativem Aufwand verarbeitet werden können.

Die erstgenannte Aufgabe wird gemäß dem kennzeichnenden Teil des Anspruchs 1 dadurch gelöst, daß der Lichtstrahl durch ein mikroelektromechanisches Spiegelsystem mit einer Vielzahl von zumindest teilweise beweglichen Mikrospiegeln gelenkt wird, die in Abhängigkeit von den digitalen Signalen derart stellungsgesteuert werden, daß der Lichtstrahl selektiv auf das Schablonenmaterial gespiegelt wird, Schablonenmaterial und Belichtungssystem kontinuierlich relativ zueinander bewegt werden und die Lichtquelle kontinuierlich leuchtet.

Grundgedanke der Erfindung ist es somit, einen Lichtstrahl über ein Spiegelsystem auf die zu belichtenden Stellen des Schablonenmaterials zu lenken, wobei das Spiegelsystem aus einer Vielzahl von Mikrospiegeln besteht, welche zumindest teilweise durch die digitalen Signale derart in ihrer Stellung zum Lichtstrahl gesteuert werden können, daß der Lichtstrahl ganz oder teilweise dem Lichtausgang zugeführt oder ausgeblendet werden kann. Solche mikroelektromechanische Spiegelsysteme sind grundsätzlich in zwei Ausführungsformen bekannt.

Bei der einen Ausführungsform befinden sich auf einem Chip eine Vielzahl von quadratischen Mikrospiegeln mit jeweils einer Fläche von 16 µm². Die Anzahl der Mikrospiegel kann mehrere Hunderttausend bis zu derzeit 2,3 Millionen betragen. Die Mikrospiegel können jeweils einzeln mittels der digitalen Signale angesteuert und dabei um eine Achse von einer Stellung, in der der auf sie treffende Teillichtstrahl zum Lichtausgang hin reflektiert wird, in eine Stellung gekippt werden, in der der Teillichtstrahl den Lichtausgang nicht verläßt, also absorbiert wird. Ein solches Spiegelsystem wird auch als "Digital Micromirror Device" (DMD) bezeichnet und innerhalb eines DLP-Systems (Digital Light Processing) verwendet (vgl. Hornbeck, Digital Light Processing for High-Brightness, High-Resolution Applications, Electronic Imaging, EI '97, 10. - 12. Februar 1997, San Jose, California, USA; Yoder, The Digital Display Technology of the Future, INFOCOM '97, 5. - 7. Juni 1997, Los Angeles, California, USA; Yoder, The State of the Art in Projection Display, Texas Instruments; Hornbeck, Digital Light Processing and MEMS: Timely Convergence for a Bright Future, MICROMACHINING AND MICROFABRICATION '95, 23. - 24. Oktober 1995, Austin, Texas, USA; US-A-4 571 603). Auf diese Literatur wird zur Beschreibung des Spiegelsystems ausdrücklich Bezug genommen.

Deraratige Spiegelsysteme sind auch schon für die Belichtung von Druckplatten, gedruckten Schaltungen und für die Stereolithographie vorgeschlagen worden, um große Mengen von Licht im blauen und ultravioletten Bereich zu modulieren (vgl. DE-A-41 21 509; US-A-5 331 338). Solche Druckplatten weisen einen starren, planen Träger auf und sind mit sehr dünnen lichtempfindlichen Beschichtungen im Bereich von 5 bis 10 µm versehen. Solche Beschichtungen können mit relativ schwachen UV-Lichtquellen, die von mikroelektromechanischen Spiegelsystemen verarbeitet werden können, gut durchgehärtet werden.

Bei Siebdruckformen ist der Schablonenträger mehr oder weniger gewölbt und wenig eigenstabil. Die Hauptmenge des Schablonenmaterials befindet sich zudem frei schwebend zwischen den Knotenpunkten des Siebes. Die mechanischen Anforderungen an das Schablonenmaterial unterscheiden sich erheblich von den Beschichtungen bei Druckplatten. Folglich werden Schichtdicken verwendet, die oft mehr als zehnmal so dick sind wie bei Druckplatten und regelmäßig zwischen 30 und 80 µm liegen. Entsprechend hoch sind die Anforderungen an die Durchhärtung solcher Beschichtungen, zumal die anschließende Entwicklung meist in Spritzanlagen stattfindet, die eine hohe mechanische Stabilität des gehärteten Schablonenmaterials voraussetzt.

Ein anderes Spiegelsystem ist als "Grating Light Valve" (GLV) bekannt. Auf einem Chip sind abwechselnd feste und vertikal bewegliche Spiegelbalken von 20 µm Länge in einem Mittenabstand von 5 µm angeordnet, wobei die beweglichen Spiegelbalken durch digitale Signale aus einer mit den festen Spiegelbalken bündigen Stellung abgesenkt werden können. Hierdurch entstehen Lichtbrechungen, die sich zu einem Lichtsignal ergänzen. Zur näheren Beschreibung wird auf folgende Literatur verwiesen: US-A-5 311 360, Science and Technology, When size matters, The Economist, 19. April 1997; Bains, Micromechanical modulator manipulates gratings, Laser Focus World, April 1997; Bains, Light in small packages miniaturizes displays, Electronic Engineering Times, 28. April 1997, Seite 37; Lieberman, "Microbridges" at heart of new MEMS displays, Electronic Engineering Times, 28. April 1997, Seite 38; Bloom, The Grating Light Valve: revolutionizing display technology, SPIE Vol. 3013, reprinted from Projection Displays III, 10.-12. Februar 1997, San Jose, California, USA; Wilson, Lieberman, Imaging device takes on TI's micromirror, Electronic Engineering Times, 16. September 1996, Seite 14 und 176.

Es hat sich überraschenderweise gezeigt, daß sich beide Arten von Spiegelsystemen sehr gut für die Belichtung von lichtempfindlichem Schablonenmaterial auf Siebdruckformen eignen, und zwar trotz der hohen Anforderungen an die Durchhärtung des Schablonenmaterials. Es kann eine hohe Auflösung im Bereich 25 µm erreicht werden. Der apparative Aufwand ist deutlich geringer als bei digital gesteuerten Lasern und Braunschen Röhren. Desweiteren hat sich erwiesen, daß über das Spiegelsystem höhere Energiedichten übertragen werden können als mit Systemen, die bisher bei der Herstellung von Siebdruckformen zur Anwendung kamen, sieht man von denjenigen ab, die mit Laserstrahlen arbeiten.

Mit Hilfe eines solchen Spiegelsystems kann ein Vollbild - gegebenenfalls unter Verwendung eines Spiegelsystems mit mehreren oder einer Vielzahl von Chips und einer oder mehreren zugeordneten Lichtquellen - erzeugt werden, so daß die zu belichtenden Bereiche vollständig und gleichzeitig mit gespiegelten Lichtstrahlen belichtet werden. Eine befriedigende Auflösung ist jedoch dann nur mit vergleichsweise großem Aufwand erzielbar. Eine zweckmäßige Lösung besteht deshalb darin, mit einem oder mehreren Chips jeweils ein Teilbild zu erzeugen und das Schablonenmaterial nach und nach durch Relativbewegungen zwischen Schablonenmaterial und Belichtungssytem zu belichten. Dies kann durch kontinuierliche Bewegung geschehen, wobei die digitalen Signale ein Scrollen des jeweiligen Teilbildes erzeugen müssen. In diesem Fall kann die Lichtquelle kontinuierlich strahlen. Alternativ dazu kann vorgesehen sein, daß Schablonenmaterial und Belichtungssystem diskontinuierlich relativ zueinander bewegt werden, so daß Teilbild neben Teilbild gesetzt wird und dann auch diskontinuierlich beleuchtet wird.

Das Schablonenmaterial sollte im UV-Längenbereich, vorzugsweise im Wellenlängenbereich > 200 nm, empfindlich sein. In diesem Falle empfiehlt sich die Verwendung einer Lichtquelle mit hohem Anteil an UV-Strahlen. Als besonders geeignet haben sich elektrodenlose, mikrowellenangeregte UV-Strahler erwiesen, wie sie von der Firma Fusion Systems Corporation, Gaithersburg (USA) angeboten werden und die in folgenden Dokumenten beschrieben sind: US-A-3 911 318; US-A-3 872 349; US-A-3 983 039; US-A-4 042 850; US-A-4 208 587; US-A-4 359 668; US-A-4 313 969; US-A-4 269 581; US-A-4 485 332; US-A-4 507 587. Solche Strahler zeichnen sich durch hohe Strahlungsdichte von wenigstens 80 W/cm aus, so daß sich eine gute Durchhärtung des vergleichsweise dicken Schablonenmaterials ergibt. Da die Strahler zudem eine geringe Wärmeabstrahlung haben, sind sie trotz ihrer hohen Strahlungsintensität für die Verwendung bei mikroelektromechanischen Spiegelsystemen geeignet.

Der zweite Teil der Aufgabe wird gemäß dem kennzeichnenden Teil des Anspruchs 6 dadurch gelöst, daß das Belichtungssystem ein mikroelektromechanisches Spiegelsystem mit einer Vielzahl von zumindest teilweise beweglichen Mikrospiegeln aufweist, auf die der Lichtstrahl gelenkt ist, und daß die Stellung der beweglichen Mikrospiegel in Abhängigkeit von den Signalen derart veränderbar ist, daß der jeweils gespiegelte Teil des Lichtstrahls entweder in den Lichtausgang geht oder nicht, Halterung und Belichtungssystem kontinuierlich relativ zueinander bewegbar sind und die Lichtquelle ein Dauerlicht erzeugt. Die hierfür im einzelnen in Frage kommenden Ausführungsformen für das mikroelektromechanische Spiegelsystem und deren Vorzüge sind vorstehend im Zusammenhang mit der Beschreibung des Verfahrens näher erläutert. Dabei kommen insbesondere Spiegelsysteme in Frage, bei denen die Mikrospiegel kippbar gelagert sind (DLP-System) oder abwechselnd starr angeordnet und beweglich sind (GLV-System). Es ist zweckmäßig, solche Spiegelsysteme mit einer Optik zu kombinieren, über die die Größe des auf dem Schablonenmaterial erzeugten Bildes bzw. Teilbildes bestimmt werden kann.

Wie schon oben erwähnt, ist es aus Gründen der Auflösung zweckmäßig, wenn das Belichtungssytem ein Teilbild erzeugt und Halterung und Belichtungssytem relativ zueinander beweglich sind. Dies kann so geschehen, daß das Belichtungssystem in einer Richtung und die Halterung in einer dazu senkrechten Richtung bewegbar sind. Bei Rundsieben sollte die Halterung drehbar sein.

Sofern es die digitale Signalaufbereitung erlaubt, sollten Halterung und Belichtungssystem kontinuierlich relativ zueinander bewegbar sein und die Lichtquelle ein Dauerlicht erzeugen. Alternativ dazu besteht die Möglichkeit, Halterung und Belichtungssytem diskontinuierlich relativ zueinander zu bewegen und dabei auch die Lichtquelle diskontinuierlich ein- und auszuschalten.

Die Lichtquelle sollte vorzugsweise einen UV-reichen Lichtstrahl erzeugen, der nach Möglichkeit auch infrarotarm sein soll. Diese Eigenschaften sind vor allem bei elektrodenlosen, mikrowellenangeregten UV-Strahlern der oben beschriebenen Art vorhanden, wobei sich solche Strahler zudem durch eine hohe Strahlungsintensität von 80 W/cm und mehr auszeichnen. Sie sind deshalb in besonderem Maße für die Durchhärtung des in relativ großer Schichtdicke vorliegenden Schablonenmaterials geeignet.

In der Zeichnung ist die Erfindung anhand eines schematisch gehaltenen Ausführungsbeispiels näher veranschaulicht. Es zeigen:

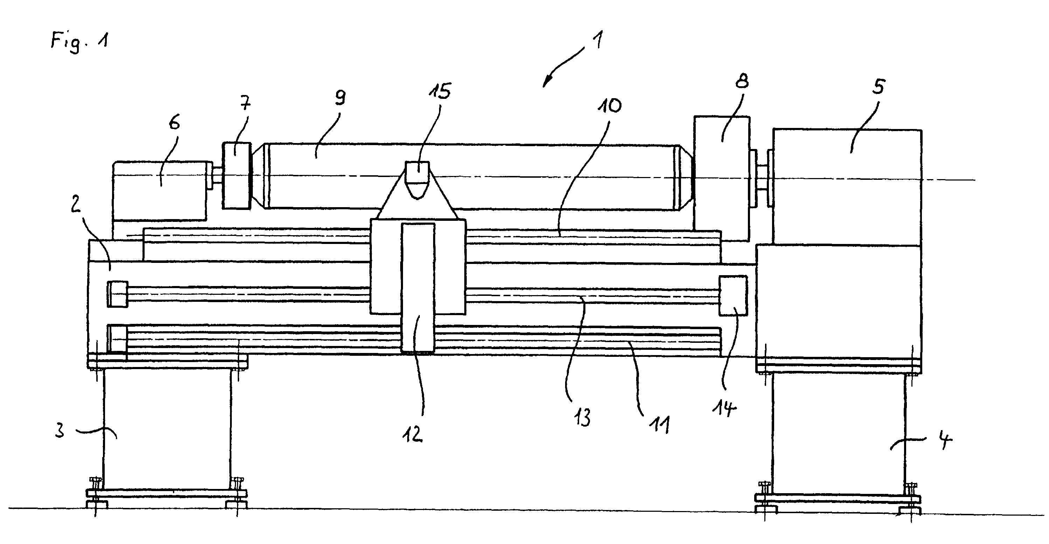

- Figur 1: die Seitenansicht einer Belichtungsvorrichtung und
- Figur 2: eine Prinzipdarstellung des Belichtungssystems für diese Belichtungsvorrichtung.

Die Belichtungsvorrichtung 1 ist prinzipiell nach Art einer Drehmaschine aufgebaut und weist ein Maschinenbett 2 auf, das auf zwei Maschinenständern 3, 4 ruht. Im Bereich der stirnseitigen Enden des Maschinenbettes 2 befinden sich auf der einen Seite ein Drehantrieb 5 und auf der anderen Seite ein Reitstock 6. Sowohl der Drehantrieb 5 als auch der Reitstock 6 weisen Schablonenaufnahmen 7, 8 auf, zwischen denen eine Rundsiebschablone 9 mit horizontaler Längsachse eingespannt ist. Über den Drehantrieb 5 und den Freilauf des Reitstockes 6 kann die Rundsiebschablone 9 um ihre horizontale Längsachse gedreht werden.

Das Maschinenbett 2 weist übereinander horizontal und parallel sich erstreckende Linearführungen 10, 11 auf, auf denen ein Schlitten 12 in Längsrichtung des Maschinenbetts 2 horizontal verschieblich gelagert ist. Zwischen beiden Linearführungen 10, 11 erstreckt sich eine Antriebsspindel 13, die in den Schlitten 12 einfaßt und durch einen Schrittmotor 14 angetrieben ist. Über den Schrittmotor 14 kann der Schlitten 12 in die jeweils gewünschte Stellung verfahren werden.

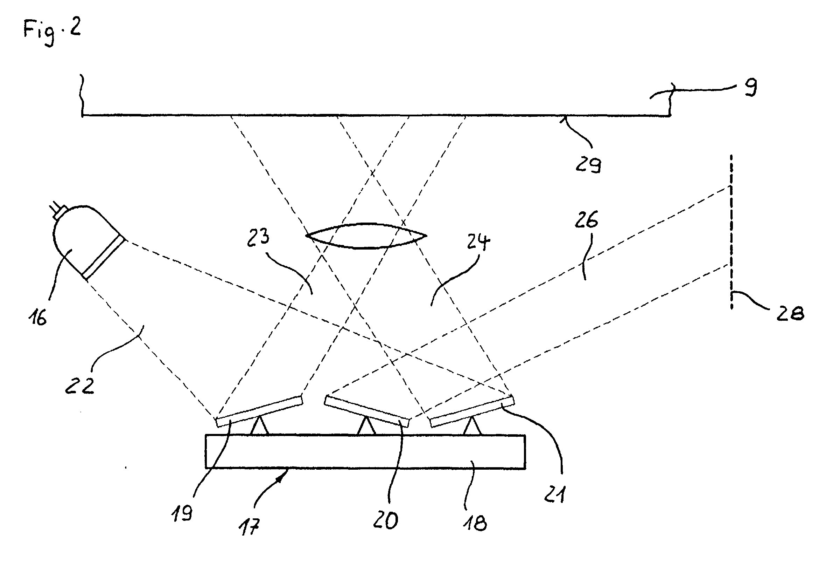

Auf dem Schlitten 12 und gegenüber der Rundsiebschablone 9 ist ein Belichtungssystem 15 angeordnet. Es besteht im wesentlichen aus einem elektrodenlosen, mikrowellenangeregten UV-Strahler 16 (Figur 2), einem mikroelektromechanischem Spiegelsystem 17 nach DMD-Technology (Digital Light Processing) und einer hier nicht näher zu sehenden Steuereinrichtung mit einer Signalquelle, die digitale Signale bereit hält. Die Funktion des Belichtungssystems 15 sei anhand von Figur 2 näher erläutert.

Das Spiegelsystem 17 ist als Halbleiterchip 18 ausgebildet, auf dem Mikrospiegel 19, 20, 21 kippbar gelagert sind. In der gewählten Ausführungsform hat der Halbleiterchip 18 508.000 Mikrospiegel 19, 20, 21 mit jeweils einer Fläche von 16 µm². Beim Beleuchtungsvorgang werden sämtliche Mikrospiegel 19, 20, 21 von dem UV-Strahler 16 bestrahlt.

In der Darstellung gemäß Figur 2 sind der obere und untere Mikrospiegel 19, 21 des UV-Strahlers 16 zugewandt und reflektieren deshalb den von dem UV-Strahler 16 ausgehenden UV-Strahls 22 in zwei Teilstrahlen 23, 24 über eine den Strahlungsausgang bildende Optik 25 auf die Rundsiebschablone 9. Der mittlere Mikrospiegel 20 ist von dem UV-Strahler 16 abgewandt gekippt, so daß der von ihm reflektierte Teilstrahl 26 nicht in die Optik 25 gelangt, sondern von einer Gehäusewandung 28 absorbiert wird.

Die Stellung der Mikrospiegel 19, 20, 21 geschieht über die digitalen Signale. Hierfür ist das sich aus nicht zu belichtenden und zu belichtenden Teilen bestehende Vollbild zuvor digitalisiert und in dieser Form dem Belichtungssystem 15 zugeführt worden. Die Steuereinrichtung sorgt dafür, daß der Schlitten 12 beim Belichtungsvorgang mittels Schrittmotor 14 intermittierend und zeilenförmig über die Rundsiebschablone 9 geführt wird. Nach jedem Bewegungsschritt werden die Mikrospiegel 19, 20, 21 entsprechend den zugeführten digitalen Signalen gekippt, und es erfolgt eine Belichtung mit dem UV-Strahler 16. Dabei wird ein Bildausschnitt bzw. Teilbild von etwa 1,5 x 2 cm erzeugt, sofern alle Spiegel den UV-Strahl 22 in Richtung auf die Optik 25 reflektieren. Danach wird der Schlitten 12 durch Ansteuerung des Schrittmotores 14 um die Ausdehnung dieses Lichtpunktes in Zeilenrichtung verschoben und erneut belichtet. Nach Abfahren einer Zeile wird die Rundsiebschablone 9 durch Ansteuerung des Drehantriebs 5 um die Ausdehnung eines Lichtpunktes in dieser Richtung verdreht und damit erneut eine Zeile abgefahren. Alternativ kann die Rundsiebschablone 9 schrittweise oder kontinuierlich in Umfangsrichtung bewegt werden, so daß in dieser Richtung Zeile neben Zeile gesetzt wird. Auch andere Bewegungskombinationen sind selbstverständlich möglich.

Sofern der Schlitten 12 in den Bereich des Übergangs einer zu belichtenden und einer nicht zu belichtenden Fläche kommt, werden diejenigen Mikrospiegel, welche bei Ausrichtung auf den UV-Strahler 16 nicht zu belichtende Bereiche bestrahlen würden, in eine abgewandte Stellung - wie der Mikrospiegel 20 - geschwenkt. Da die Mikrospiegel 19, 20, 21 außerordentlich klein sind und zudem die Optik 25 nur eine geringfügige Vergrößerung verursacht, wird eine Auflösung in der Größenordnung von 25 µm und kleiner erreicht. Je nach Optik können feinste Details von minimal 5 µm übertragen werden.

Vor dem Belichtungsvorgang ist auf die Rundsiebschablone 9 ein lichtempfindliches, insbesondere UV-empfindliches Schablonenmaterial 29, aufgetragen worden. Hierfür kommen Zusammensetzungen auf der Basis lichtempfindlicher Acrylate - Styrole - SbQ-modifizierte Bindemittel in Frage, die zusätzlich mit Photoinitiatoren versetzt sein können, welche im Wellenlängenbereich 280 bis 600 nm sensibel sind. Zur Erhöhung der chemischen Resistenz finden Epoxid-, Polyurethan-, Harnstoff-, Melamin- und Benzoguanaminharze verwendung, die mit den Grundstoffen Gelatine, Polyvinylalkohol, Polyvinylacetaten oder deren Copolymeren sowie Phenol- oder Kresolharzen abreagieren. Der Auftrag des lichtempfindlichen Materials kann mittels einer Rakel, im Spritzverfahren, durch Tauchen, durch Streichen, durch Aufkleben eines lichtempfindlichen Films oder durch Elektrostatik geschehen. Die Beschichtung 29 wird anschließend getrocknet und kann dann in der oben beschriebenen Weise belichtet werden.

Für die Beschichtung 29 können beispielhaft folgende Formulierungen verwendet werden:

### 1. Negativ-Resist

Als Beispiel einer wäßrigen Kopierschichtemulsion auf der Basis einer SbQ-Schicht (SbQ = quantärneres Styrylpyridinium-Fotoinitiator) sei hier die folgende Formulierung aufgeführt:

| | |
|---|---|
| 80-95 g | SPP®-US-130 |
| 0,1-1 g | Luconylblau 7080® |
| 0,1-0,4 g | Acticid HF® |
| 0,1-0,5 g | Agitan 290® |
| 1-10 g | Dibutylphthalat |
| 0,1-1 g | Surfynol 440® |

SPP ist ein eingetragenes Warenzeichen der Produits Chimiques Auxiliaires et de Synthèse. Luconylblau ist ein eingetragenes Warenzeichen der Bayer AG. Acticid ist ein Produkt der Thor Chemie GmbH. Agitan ist ein eingetragenes Warenzeichen der Münzing Chemie. Surfynol ist ein eingetragenes Warenzeichen der Air Products and Chemicals Inc.

Die Emulsion wird in für den Flach-Siebdruck üblichen Verarbeitungsweisen aufgetragen und 30 min bei 40°C getrocknet. Danach ist die Schicht digital belichtbar und wäßrig entwickelbar. Die Belichtung ist mit Licht der Wellenlänge > 400 nm - < 480 nm möglich. Die Belichtungszeit muß der Schichtdicke der Emulsion und der verwandten Lampe angepaßt werden.

### 2. Positiv-Resist

Eine alkalisch entwickelbare Kopierschicht, die Anwendung im Offsetdruck bzw. der Galvanoschablonenherstellung finden kann, baut sich aus folgenden Komponenten auf:

| | |
|---|---|
| 10-40 g | Ebecryl® 770 |
| 10-40 g | Ebecryl® 1559 |
| 0,5-2 g | Modaflow® |
| 15-30 g | Methylethylketon |
| 5-20 g | Acrylsäure |
| 1-5 g | Irgacure® 369 |
| 1-4 g | Irgacure® 651 |

Ebecryl ist ein eingetragenes Warenzeichen der Fa. UCB-Chemicals. Irgacure ist ein eingetragenes Warenzeichen der Fa. Ciba-Geigy. Modaflow ist ein eingetragenes Warenzeichen der Monsanto Company.

Je nach Spritz-, Tauch- oder Schleuderverfahren wird die lichtempfindliche Schicht noch mit Methylethylketon verdünnt und ca. 30 min bei ca. 40°C auf dem Substrat getrocknet. Nach der Belichtung >400 nm sind belichtete Stellen mit 3-5 %iger Natronlauge bzw. einer 3-5 %igen Natriumcarbonatlösung auszuwaschen. Die unbelichteten Teile sind wasser- und säurefest und können bei Temperaturen um 50°C auch in galvanischen Bädern eingesetzt werden.

### 3. Negativ-Resist

Dieser Resist kann Anwendung finden, wenn eine Wasserverunreinigung vermieden werden muß und Lösungsmittel zurückgewonnen wird. Die Formulierung ist geeignet für die Herstellung von Offsetdruckplatten.

| | |
|---|---|
| 10-30 g | Beckopox® EP 304 |
| 10-30 g | Ebecryl® 1559 |
| 5-15 g | Ebecryl® 770 |
| 1-6 g | Irgacure® 369 |
| 1-4 g | Irgacure® 651 |
| 0,5-2 g | Modaflow® |
| 1-10g | Trimethylolpropantriacrylat (TMPTA) |

Beckopox ist ein eingetragenes Warenzeichen der Vianova Resins. Je nach Verarbeitungsmethode muß die Viskosität mit Methyl-ethylketon eingestellt werden. Die lichtempfindliche Schicht ist mittels Tauchen, Schleudern, Spritzen oder Rakeln aufzutragen. Nach einer ca. 30 minütigen Tocknung bei 40°C kann die Schicht digital belichtet werden (>400 <480 nm).

## Patentansprüche

1. Verfahren zur Herstellung von Siebdruckformen durch selektive Belichtung von deren lichtempfindlichen Schablonenmaterial (29), bei dem ein Belichtungssystem (15) mit einer einen Lichtstrahl (22) erzeugenden Lichtquelle (16) mittels einer digitale Signale liefernden Signalquelle derart gesteuert wird, daß die gewünschten Stellen des Schablonenmaterials (29) belichtet werden, und bei dem die Siebdruckform anschließend entwickelt wird, **dadurch gekennzeichnet, daß** der Lichtstrahl (22) durch ein mikroelektromechanisches Spiegelsystem (17) mit einer Vielzahl von zumindest teilweise beweglichen Mikrospiegeln (19, 20, 21) gelenkt wird, die in Abhängigkeit von den digitalen Signalen derart stellungegesteuert werden, daß der Lichtstrahl 22 selektiv auf das Schablonenmaterial (29) gespiegelt wird, Schablonenmaterial (29) und Belichtungssystem (15) kontinuierlich relativ zueinander bewegt werden und die Lichtquelle (16) kontinuierlich leuchtet.

2. Verfahren nach Anspruch 1, **dadurch gekennzeichnet, daß** der Lichtstrahl (22) von einer Vielzahl von einzeln beweglichen Mikrospiegeln (19, 20, 21) abgelenkt wird.

3. Verfahren nach Anspruch 1, **dadurch gekennzeichnet, daß** der Lichtstrahl von Mikrospiegeln abgelenkt wird, die nur zum Teil beweglich sind.

4. Verfahren nach einem der Ansprüche 1 bis 3, **dadurch gekennzeichnet, daß** das Schablonenmaterial im UV-Längenwellenbereich empfindlich ist.

5. Verfahren nach einem der Ansprüche 1 bis 5, **dadurch gekennzeichnet, daß** für das Schablonenmaterial (29) ein Material verwendet wird, das im Wellenlängenbereich > 200 nm empfindlich ist.

6. Belichtungsvorrichtung (1) der Durchführung des Verfahrens nach einem der Ansprüche 1 bis 5 mit einer Halterung (7, 8) für die Siebdruckform (9), einem Belichtungssystem (15), das eine einen Lichtstrahl (22) erzeugende Lichtquelle (16) und einen Lichtausgang (25) aufweist, und mit einer digitale Signale liefernden Signalquelle, welche mit dem Belichtungssystem (15) in der Weise in Verbindung steht, daß entsprechend den Signalen die gewünschten Stellen des Schablonenmaterials (29) belichtbar sind, **dadurch gekennzeichnet, daß** das Belichtungssystem (15) ein mikroelektromechanisches Spiegelsystem (17) mit einer Vielzahl von zumindest teilweise beweglichen Mikrospiegeln (19, 20, 21) aufweist, auf die der Lichtstrahl (22) gelenkt ist, und daß die Stellung der beweglichen Mikrospiegel (19, 20, 21) in Abhängigkeit von den Signalen derart veränderbar ist, daß der jeweils gespiegelte Teil des Lichtstrahls (22) entweder in den Lichtausgang geht oder nicht, Halterung (7, 8) und Belichtungssystem (15) kontinuierlich relativ zueinander bewegbar sind und die Lichtquelle ein Dauerlicht erzeugt.

7. Belichtungsvorrichtung nach Anspruch 6, **dadurch gekennzeichnet, daß** im Bereich des Lichtausgangs eine Optik (25) vorgesehen ist.

8. Belichtungsvorrichtung nach Anspruch 6 oder 7, **dadurch gekennzeichnet, daß** die Mikrospiegel (19, 20, 21) kippbar gelagert sind.

9. Belichtungsvorrichtung nach Anspruch 6 oder 7, **dadurch gekennzeichnet, daß** die Mikrospiegel abwechselnd starr angeordnet und abwechselnd beweglich sind.

10. Belichtungsvorrichtung nach Anspruch 6, **dadurch gekennzeichnet, daß** das Belichtungssystem (15) in einer Richtung und die Halterung (7, 8) in einer dazu senkrechten Richtung bewegbar sind.

11. Belichtungsvorrichtung nach Anspruch 10, **dadurch gekennzeichnet, daß** die Halterung (7, 8) drehbar ist.

12. Belichtungsvorrichtung nach einem der Ansprüche 6 bis 11, **dadurch gekennzeichnet, daß** die Lichtquelle (16) einen UV-reichen Lichtstrahl (22) erzeugt.

13. Belichtungsvorrichtung nach einem der Ansprüche 6 bis 12, **dadurch gekennzeichnet, daß** die Lichtquelle (16) einen infrarotarmen Lichtstrahl (22) erzeugt.

## Claims

1. A method for manufacturing screen printing forms by selective exposure of their light-sensitive stencil material (29) wherein an exposure system (15) having a light source (16) which generates a light beam (22) is controlled by means of a signal source which delivers digital signals such that the desired points on the stencil material (29) are exposed and wherein the screen printing form is subsequently developed, **characterised in that** the light beam (22) is guided by a micro-electromechanical mirror system (17) comprising a plurality of at least partly movable micro-mirrors (19, 20, 21) which are position-controlled depending on the digital signals such that the light beam (22) is selectively reflected onto the stencil material (29), the stencil material (29) and exposure system (15) are moved continuously relative to one another and the light source (16) shines continuously.

2. The method according to claim 1, **characterised in that** the light beam (22) is deflected by a plurality of individually movable micro-mirrors (19, 20, 21).

3. The method according to claim 1, **characterised in that** the light beam is deflected by micro-mirrors which are only partly movable.

4. The method according to any one of claims 1 to 3, **characterised in that** the stencil material is sensitive in the UV wavelength range.

5. The method according to any one of claims 1 to 5, **characterised in that** a material which is sensitive in the wavelength range > 200 nm is used for the stencil material (29) .

6. An exposure device (1) for implementing the method according to any one of claims 1 to 5 comprising a holder (7, 8) for the screen printing form (9), an exposure system (15) which has a light source (16) generating a light beam (22) and a light exit (25), and comprising a signal source delivering a digital signal which is in communication with the exposure system (15) such that the desired points on the stencil material (29) can be exposed according to the signals, **characterised in that** the exposure system (15) has a micro-electromechanical mirror system (17) with a plurality of at least partly movable micro-mirrors (19, 20, 21) onto which the light beam (22) is directed and that the position of the movable micro-mirrors (19, 20, 21) is variable depending on the signals such that the respectively reflected part of the light beam (22) either goes into the light exit or not, the holder (7, 8) and exposure system (15) are continuously movable relative to one another and the light source generates a continuous light.

7. The exposure device according to claim 6, **characterised in that** an optical system (25) is provided in the area of the light exit.

8. The exposure device according to claim 6 or claim 7, **characterised in that** the micro-mirrors tiltably (19, 20, 21) run on bearings.

9. The exposure device according to claim 6 or claim 7, **characterised in that** the micro-mirrors are alternately rigidly arranged and alternately movable.

10. The exposure device according to claim 6, **characterised in that** the exposure system (15) is movable in one direction and the holder (7, 8) is movable in a direction perpendicular thereto.

11. The exposure device according to claim 10, **characterised in that** the holder (7, 8) is rotatable.

12. The exposure device according to any one of claims 6 to 11, **characterised in that** the light source (16) generates a light beam (22) which a high amount of UV-light.

13. The exposure device according to any one of claims 6 to 12, **characterised in that** the light source (16) generates a light beam (22) low in infrared.

## Revendications

1. Procédé pour la fabrication des formes sérigraphiques par exposition sélective de leur matériau de pochoir photosensible (29), pour lequel un système d'exposition (15) avec une source de lumière (16) engendrant un rayon lumineux (22) est commandé au moyen d'une source de signaux délivrant des signaux numériques de telle sorte que les emplacements désirés du matériau de pochoir photosensible (29) sont exposés, et pour lequel le pochoir sérigraphique est ensuite développé, **caractérisé en ce que** le rayon lumineux (22) est guidé par un système de miroirs microélectromécaniques (17) avec une multitude de micromiroirs (19, 20, 21) au moins partiellement mobiles, qui sont commandés en position en fonction des signaux numériques de telle sorte que le rayon lumineux (22) est réfléchi sélectivement sur le matériau de pochoir photosensible (29), **en ce que** le matériau de pochoir photosensible (29) et le système d'exposition (15) sont déplacés continûment l'un par rapport à l'autre et **en ce que** la source de lumière (16) est allumée en continu.

2. Procédé selon la revendication 1, **caractérisé en ce que** le rayon lumineux (22) est dévié par une multitude de micromiroirs mobiles individuels (19, 20, 21).

3. Procédé selon la revendication 1, **caractérisé en ce que** le rayon lumineux est dévié par des micromiroirs qui ne sont mobiles que partiellement.

4. Procédé selon l'une quelconque des revendications 1 à 3, **caractérisé en ce que** le matériau de pochoir est sensible dans la gamme de longueurs d'onde de l'UV.

5. Procédé selon l'une quelconque des revendications 1 à 5, **caractérisé en ce qu'**un matériau qui est sensible dans la gamme de longueurs d'onde > 200 nm est utilisé pour le matériau de pochoir (29).

6. Dispositif d'exposition (1) de l'exécution du procédé selon l'une quelconque des revendications 1 à 5, avec une fixation (7, 8) pour la forme sérigraphique (9), un système d'exposition (15), qui comporte une source de lumière (16) engendrant un rayon lumineux (22) et une sortie de la lumière (25) et avec une source de signaux délivrant des signaux numériques, laquelle se trouve en relation avec le système d'exposition (15) de telle sorte qu'en fonction des signaux, les emplacements désirés du matériau de gabarit (29) peuvent être exposés, **caractérisé en ce que** le système d'exposition (15) comporte un système microélectromécanique de miroirs (17) avec une multitude de micromiroirs (19, 20, 21) au moins partiellement mobiles, sur lesquels le rayon lumineux (22) est dévié, et **en ce que** la position des micromiroirs mobiles (19, 20, 21) peut être modifiée en fonction des signaux de telle sorte que la partie respectivement reflétée du rayon lumineux (22) va soit dans la sortie de la lumière, soit non, la fixation (7, 8) et le système d'exposition (15) sont mobiles continûment l'un par rapport à l'autre et la source de lumière engendre une lumière continue.

7. Dispositif d'exposition selon la revendication 6, **caractérisé en ce qu'**une optique (25) est prévue dans la zone de la sortie de la lumière.

8. Dispositif d'exposition selon la revendication 6 ou 7, **caractérisé en ce que** les micromiroirs (19, 20, 21) sont montés basculants.

9. Dispositif d'exposition selon la revendication 6 ou 7, **caractérisé en ce que** les micromiroirs (19, 20, 21) sont disposés alternativement fixes et alternativement mobiles.

10. Dispositif d'exposition selon la revendication 6, **caractérisé en ce que** le système d'exposition (15) est mobile dans une direction et la fixation (7, 8) dans une direction perpendiculaire à cette dernière.

11. Dispositif d'exposition selon la revendication 10, **caractérisé en ce que** la fixation (7, 8) est mobile en rotation.

12. Dispositif d'exposition selon l'une quelconque des revendications 6 à 11, **caractérisé en ce que** la source de lumière (16) engendre un rayon lumineux (22) riche en UV.

13. Dispositif d'exposition selon l'une quelconque des revendications 6 ä 12, **caractérisé en ce que** la source de lumière (16) engendre un rayon lumineux (22) pauvre en infrarouges.
